# EUROPEAN PATENT SPECIFICATION

(11) **EP 0 724 714 B1**
(45) Date of publication and mention of the grant of the patent: **02.02.2000**
(21) Application number: 94901169.6
(22) Date of filing: 18.10.1993
(51) Int. Cl.: G01F 1/32

(54) **VORTEX FLOWMETER ELECTRONICS**
ELEKTRONISCHE SCHALTUNG EINES WIRBELDURCHFLUSSMESSER
DISPOSITIF ELECTRONIQUE POUR DEBITMETRE A VORTEX

(43) Date of publication of application: 07.08.1996
(73) Proprietor: ROSEMOUNT INC., Eden Prairie, MN 55344 (US)
(72) Inventor: KLEVEN, Lowell, Eden Prairie, MN 55347 (US); FRICK, Roger, Hackensack, MN 56452 (US)
(74) Representative: Cross, Rupert Edward Blount
(86) International application number: US9309942
(87) International publication number: WO9511425

(56) References cited:
- EP-A- 0 069 008
- EP-A- 0 333 575
- WO-A-91/19201
- GB-A- 2 059 699
- US-A- 3 709 034
- US-A- 4 966 040
- PATENT ABSTRACTS OF JAPAN vol. 10, no. 195 (P-475) <2251> 09 July 1986 & JP,A,61 038 420 (OVAL ENG CO) 24 February 1986
- PATENT ABSTRACTS OF JAPAN vol. 8, no. 109 (P-275) <1546> 22 May 1984 & JP,A,59 018 421 (OVAL KIKI KOGYO) 30 January 1984
- REGELUNGSTECHNISCHE PRAXIS, vol. 26,no. 8, August 1984 MÜNCHEN,DE, pages 369-373, R. HILLEBRAND 'INDUSTRIERECHNER ERSCHLIESSEN NEUE ANWENDUNGSGEBIETE'

## Description

### BACKGROUND OF THE INVENTION

The present invention relates to flowmeters, such as vortex shedding meters or swirlmeters which are responsive to a fluid flow. In particular, it relates to electronics for such meters which reduce noise in a flow responsive signal.

Flowmeters sense the flow of liquid and gases in conduits and produce a noise contaminated flow responsive signal. Under certain circumstances, the presence of an obstacle or shedder in a flow conduit causes periodic vortices. A vortex flowmeter produces shedding vortices from a bluff body. The frequency of these vortices is directly proportional to the flow velocity in the meter. The shedding vortices produce an alternating differential pressure across the bluff body at the shedding frequency. This differential pressure is converted to an electrical signal by piezoelectric crystals or other differential pressure devices. The magnitude of the differential pressure or electric signal 1 is proportional to ρ, where ρ is the fluid density and V is the fluid velocity. When the ratio of pipe diameter to the size of the shedding bar is held constant, the signal is proportional to D²F², where D is the inside diameter of the meter and F is the shedding frequency. The flowmeter produces pulses having a frequency proportional to the flow rate. The swirlmeter produces a similar flow responsive signal by measuring the vortex precession frequency produced by swirling the flow, then passing the flow through a downstream contraction and expansion.

The vortex flowmeter signal comprises a fundamental signal which has a fundamental frequency representative of the flow and an associated noise signal at various frequencies caused by fluid turbulence and other unrepeatable factors such as pipe vibrations, common mode pressure variation and noise from acoustic sources. Pipe vibrations caused by pumps, motors and unsupported sections of pipe are usually in the O to 100 Hz range and common mode pressure noise in the 10 to 1000 Hz range, while acoustic noise is generally above 100 Hz. Fluid turbulence results in noise on both sides of the fundamental frequency. Because fluid turbulence noise generally increases in amplitude as the flow velocity increases, it is particularly troublesome when low frequency turbulent noise below the fundamental frequency is disproportionally amplified by signal processing electronics.

Flowmeters, like vortex shedding meters and swirlmeters are designed for a variety of applications encompassing wide ranges of flow rates, pipe diameters and fluid densities. Consequently, such meters operate over a relatively large dynamic range. When fluid density is constant, the flow velocity range is typically 25 to 1. Even with the flow range at 25 to 1, signal amplitude will change by a ratio of 625 to 1, because the signal is proportional to the square of the velocity. When variable fluid densities are taken into account, which range between 1 and 800 in fluids such as atmospheric air to liquids, a frequency change of 100 to 1 is possible for a specific meter size and will result in a maximum signal amplitude range from 10,000 to 1. Unfortunately, the signal-to-noise ratio changes markedly over the ranges. Furthermore amplitude and frequency modulation of the flow signal introduces low and high frequency noise that causes problems for some signal conditioning systems. Consequently, a single filtering system is needed which improves variations in signal to noise ratio over a large dynamic range encompassing wide ranges of flow, density and diameter yet differentiates flow signal from unwanted noise.

In order to provide electronics to improve the signal to noise ratio over a large dynamic range, some electronics control the amplitude of the vortex signal through a feedback method. Other systems utilize a phase lock loop that averages phase errors. Both amplitude control and phase lock loop systems have a response time set to the lowest frequency or data rate. As a result, high frequency response suffers.

A single set of electronics having an improved high frequency response which proportionally amplify low frequencies is desired. There is also a need for electronics which have a sufficiently fast response time to prevent loss of pulses during flow transients.

### SUMMARY OF THE INVENTION

The present invention is a transmitter sensing a physical parameter such as flow. Filter means in the transmitter receive a noise contaminated input signal representative of the physical parameter which has a fundamental frequency varying responsively to the physical parameter. Filter means filter the input signal with a current high pass (HP) filter characteristic to produce a filtered signal having a frequency representative of the physical parameter. The frequency characteristic of the HP filter means is selected from a family of preselectable HP filters having varying corner frequencies. Each HP filter in the family has a unique switchup and a unique switchdown value assigned to it. The electronics include timer means which provide a period timer value representative of the time between period boundaries of the filtered signal and also provide a present timer value representative of the elapsed time since a last period boundary of the filtered signal. The electronics also include adaptive response means which select a current HP filter for use in the filter means. The adaptive means use one selection method when the flow is increasing and another selection method when the flow decreases. For increasing flow, a HP filter corner higher in frequency than the current filter corner is selected when the period timer value is less than a switchup value corresponding to the filter having such next higher corner frequency. For decreasing flow, a HP filter corner lower in frequency than the current filter corner is selected when the present timer value exceeds a switchdown value corresponding to such lower filter characteristic. The adaptive response makes the invention useful for instruments responsive to the square of the fluid velocity, such as vortex flowmeters or which must respond to a large dynamic input range of frequencies. Finally, output means convert the signal from the filter means into a transmitter output, typically a 4-20 mA current or a frequency output, which is representative of such physical parameter.

The filter means may also include low pass (LP) filter means having a variable low frequency corner which is set as a function of the diameter of a pipe through which the fluid flows and the density of the fluid. Furthermore, there is Schmitt trigger means receiving the filtered signal and coupled between the timer means and the adaptive response means for providing a stable filtered signal to the adaptive response means. In an automated LP corner setting mode, the adaptive response means decreases the frequency of the LP filter corner frequency until a first corner frequency is encountered where the output of the Schmitt trigger is no longer a square wave, and then increases such first corner frequency to a second corner frequency greater than the first corner frequency.

### BRIEF DESCRIPTION OF THE DRAWINGS

FIG. 1 is a block diagram of a vortex flowmeter in accordance with the present invention.
FIG. 2A and 2B are graphs of the frequency responses of a two pole low pass filter and a four pole high pass filter having selectable frequency characteristics in accordance with the present invention.
FIG. 3 is a graph of input signal level versus frequency for a bandpass filter, as if acting at the input of the filter and Schmitt trigger combination with two families of vortex meter flow curves superimposed thereon.
FIG. 4 is a graph of input signal level versus frequency for a combined bandpass filter, having the 3 Hz LP characteristic selected, as if acting at the input of the filter and the Schmitt trigger, with a single flowmeter curve superimposed thereon.
FIG. 5 is a block diagram of an alternate embodiment of vortex flowmeter in accordance with the present invention.

### DETAILED DESCRIPTION OF THE PREFERRED EMBODIMENTS

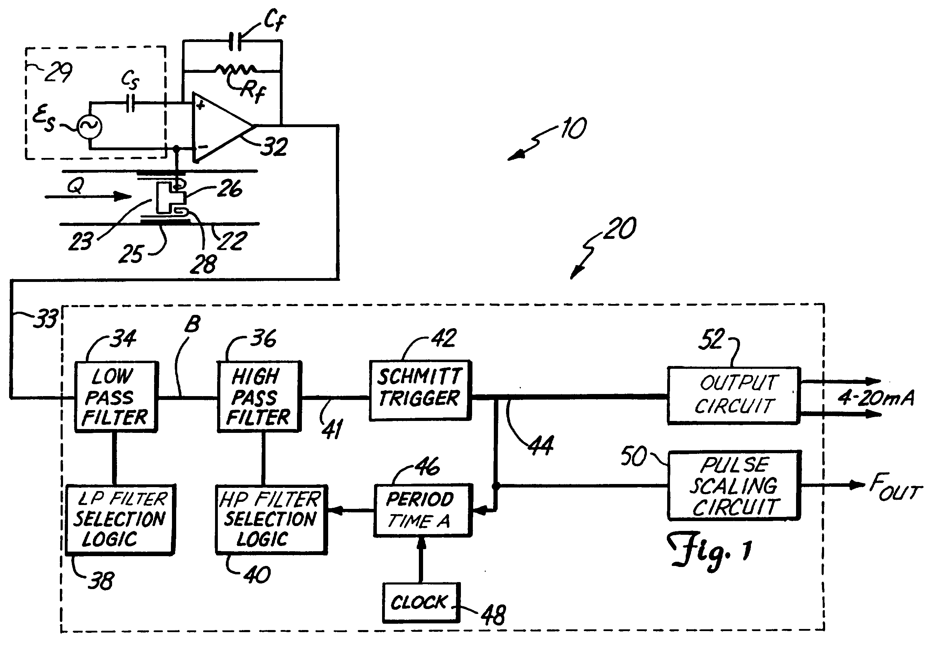

FIG. 1 shows a vortex flowmeter 10 including electronics generally indicated at 20 for conditioning a vortex sensor signal 33. Electronics 20 increases the signal-to-noise ratio of signal 33 and produces both a 4-2OmA current representative of flow and a square wave output Fₒᵤₜ having a frequency proportional to the frequency of signal 33.

Electronics 20 are applicable to field mounted process control instruments which must respond to a wide dynamic range of input frequencies. Electronics 20 are particularly appropriate for meters sensing a physical parameter responsive to a power of the variable which the output represents. For example, both vortex flowmeters and swirlmeters measure fluid flow by sensing an amplitude modulated pressure signal whose frequency is proportional to the flow and output a signal representative of the flow rate.

A liquid or gas fluid 23 creates a flow, Q, through a pipe 22. A vortex meter housing 25 having a bluff body 26 therein is located in pipe 22. When fluid 23 flows past body 26, shedding vortices 28 having a frequency representative of the flow are produced. Bluff body 26, or subsections thereof, move in response to the pressure difference across bluff body due to the vortex shedding. Movement is sensed by, for example, a piezoelectric sensor shown at 29. Sensor 29 is modelled by a voltage source E_{S} and a series capacitor C_{S}. The magnitude of the output signal from the piezoelectric sensor is proportional to the differential pressure, which is proportional to ρV², where ρ is the fluid density and V is the velocity of fluid 23, and also proportional to ρD²F² (when the ratio of the size of the shedding bar to the pipe diameter is held constant), where D is the inside diameter of meter housing 25 and F is the shedding frequency.

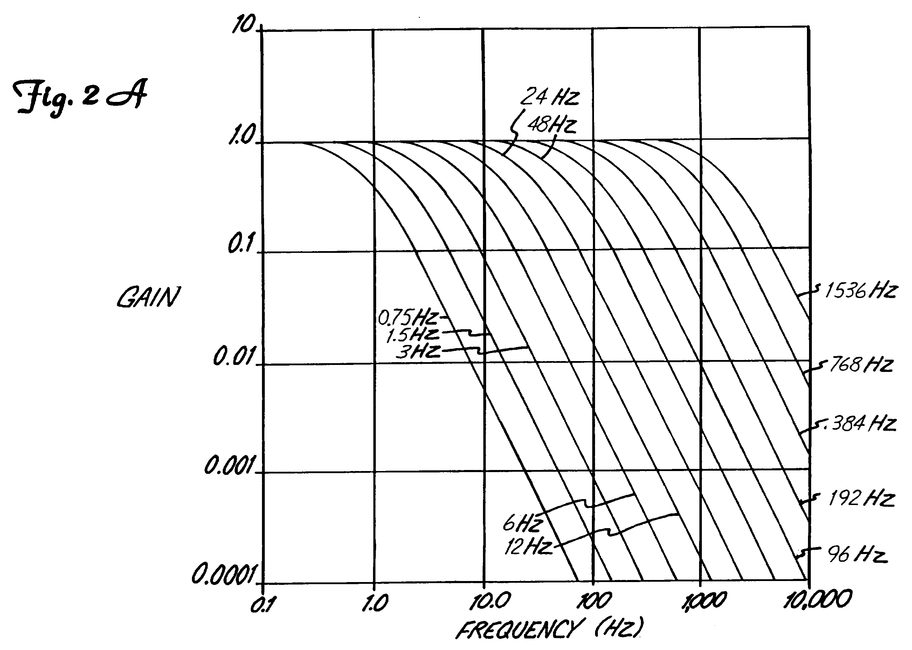

The output of the piezoelectric sensor is coupled to a charge amp 32 which includes capacitor C_{F} and resistor R_{F} and outputs vortex sensor signal 33. Adjustable two-pole low pass (hereinafter LP) filter 34 conditions signal 33 to remove undesirable high frequency noise. The corner of LP filter 34 is set at or slightly below the lowest flow frequency expected in a specific application and therefore needs only to be set once per application. FIG. 2A shows the frequency responses for each of the preselectable LP filter 34 characteristics, specifically set in this embodiment of the invention for corner frequencies between 0.75 and 1536 Hz.

As the magnitude of vortex signal 33 changes substantially proportionally as the square of fluid 23 velocity and filter 34 has a 1/F² response for frequencies above the filter's low frequency corner, the output of filter 34 is substantially constant, or flattened, at frequencies above the selected low frequency corner. This flattening phenomenon is desirable because it attenuates noise occurring at higher frequencies and at larger amplitudes more than it attenuates the vortex sensor signal 33 and provides a more consistent signal to noise ratio over a given flow range. As a result, LP filter 34 prevents the flowmeter from needlessly responding to noise at higher frequencies and at larger amplitudes than signal 33 because of the flattening phenomenon.

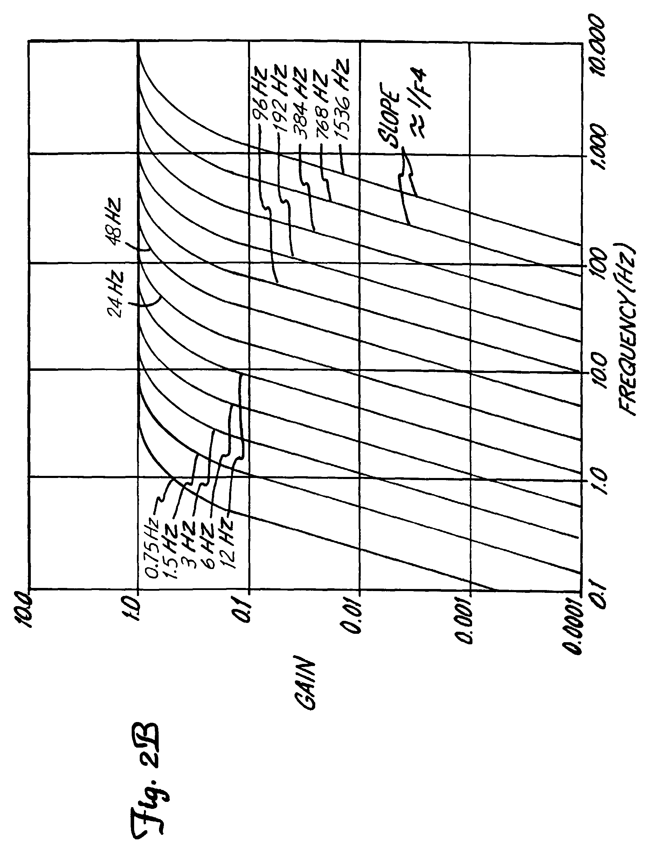

FIG. 2B shows the frequency response of four-pole high pass (hereinafter HP) filter 36 for each preselectable HP corner frequency. The family of LP and HP filter characteristics is chosen as appropriate for the maximum and minimum flows,the fluid density, and the meter size anticipated for use with electronics 20. Filter 36 attenuates the low frequency noise which LP filter 34 does not attenuate and produces signal 41. The frequency response of filter 36 has four poles because of the effective loss of two poles from filter 34 in the frequency range from the LP corner to the HP corner. The HP corner frequency is typically larger than the LP corner frequency in order to provide more noise immunity for low frequency noise. Without filter 36, this low frequency noise present at the output of HP filter 34 would be particularly troublesome at high flow rates when the low frequency noise has an amplitude greater than the amplitude of the vortex signal.

Schmitt trigger 42 squares the output of HP filter 36 to produce square wave signal 44, which has a frequency substantially equal to the frequency of vortex sensor signal 33. The voltage at which the output of trigger 42 changes state is preferably set to approximately twenty-five percent of the voltage level measured at signal 41. The measurement should be performed over the flattened section of the response found at frequencies above the low frequency corner of filter 34 in order to provide an optimally stable square wave output.

Period timer 46, clocked by clock 48, provides an elapsed time since a last period boundary of output signal 44 to HP filter selection logic 40. The elapsed time typically corresponds to the time since the last rising edge of signal 44, but alternatively may be made over more than one period to reduce the effect of jitter on HP filter selection. Jitter refers to the random variation in the main frequency component of the vortex signal 33. Averaging over several periods increases the response time to flow transients.

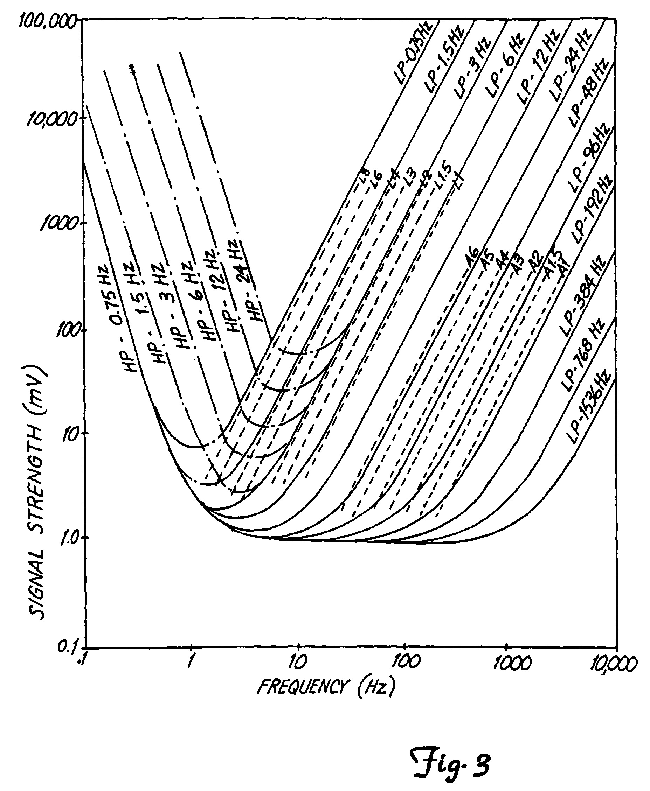

FIG. 3 shows the set of preselectable LP filter attenuation characteristics (in solid lines) between 0.75 Hz and 1536 Hz. The family of HP filter attenuation characteristics (in dotted/dashed line) is provided only for the 3 Hz LP characteristic. For this example, the 3 Hz LP characteristic corresponds to LP filter 34 and one of the characteristics of the HP family corresponds to HP filter 36. The envelope formed by the 3 Hz LP characteristic and whichever HP characteristic is selected defines the area where signal 41 has an amplitude large enough to exceed the voltage threshold necessary to make the output of trigger 42 change state. Superimposed on these filter characteristics are the flow curves for two families of pipes. Curves L1-L8 are for pipes carrying liquids of density 62.4 lb/ft³ at atmospheric pressure and ranging in diameter between one and eight inches. Flow curves A1-A6 are for a family of pipes carrying air at atmospheric pressure and ranging in diameter between one and six inches. Increasing fluid density moves the curves vertically upward for the same velocity range and increasing diameter moves the curves to the left for the same velocity range. As the magnitude of the output signal of vortex signal 33 is proportional to ρD²F². Each application will typically have a different flow curve. Increasing flows are represented as successively higher operating points on the same flow curve. Once the flow curve for the instant application is substantially known, the proper LP filter characteristic can be selected.

There must be enough of an amplitude margin between the flow curve and the LP characteristic to provide for stable operation of Schmitt trigger 42. A margin of 4:1 between the amplitude of signal 41 to the voltage required to trigger Schmitt trigger 42 is preferred to allow for small amplitude modulations and for filter switching transients.

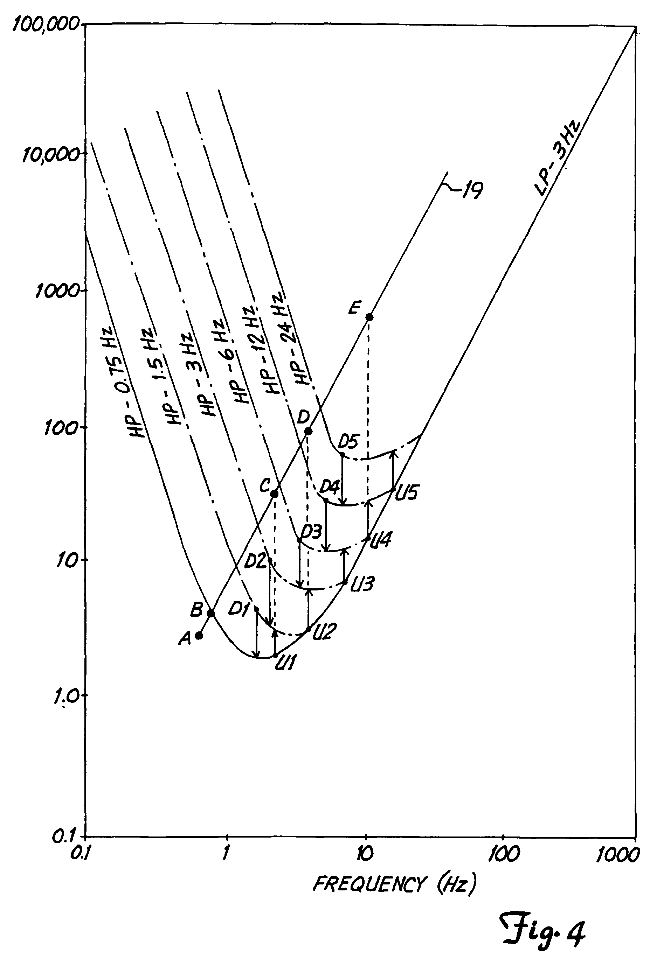

FIG. 4 shows a single LP filter characteristic (a 3 Hz filter characteristic) and a family of HP filter characteristics (0.75 Hz, 1.5 Hz, 3.0 Hz, etc.). Superimposed on these filter characteristics is an operating curve for a pipe of eight inch diameter carrying liquid of density 62.4 lbs/ft³, indicated at reference designator 19. Points A, B, C, D and E represent different operating points on curve 19. Point A has the lowest flow of the five points and points B, C, D and E have successively faster flow rates. As discussed above, the envelope formed by the 3 Hz LP characteristic and whichever HP characteristic is selected defines the area where signal 41 has an amplitude large enough to exceed the voltage threshold necessary to make the output of Schmitt trigger 42 change state. For example, consider application of signal 33 to the combination of filter 34,36 and trigger 42 when the 0.75 LP characteristic is selected for filter 34. If signal 33 were of the amplitude and frequency represented at point A on curve 19, signal 44 would be a constant voltage, whereas application of signal 33 represented at point C on curve 19 would result in a square wave signal at signal 44.

HP filter selection logic 40 recognizes two switchpoints corresponding to each of the preselected HP filter characteristics (a "switchup point" and a "switchdown point") and recognizes which HP filter characteristic is currently used in HP filter 36, (the "current filter characteristic"). Each switchpoint represents a timer value representative of a frequency at which logic 40 should select a new filter characteristic. Logic 40 continually monitors the value of period timer 46, (the "present timer value"). The switchup and switchdown point for each preselectable filter characteristic introduce hysteresis, which minimizes excessive filter switching caused by frequency jitter in vortex signal 33.

When the flow increases from a no-flow condition in pipe 22, signal 44 becomes a square wave at point B. HP filter characteristic 0.75 Hz is set by default. Period timer 46 is reset by a period boundary of signal 44 and consequently represents the elapsed time since the last period boundary of signal 44. When the present timer value at the end of a signal 44 period, (the "period timer value"), is less than a switchup point corresponding to the HP filter characteristic having the next highest frequency corner, logic 40 immediately selects the filter with such next higher frequency corner for use in filter 36. For example, when the flow has increased to point C, the period timer value at the end of a signal 44 period is less than the switchup point corresponding to the 1.5 Hz HP filter characteristic shown at U1 and logic 40 will immediately select the 1.5 Hz characteristic. When flow increases to point D, the period timer value at the end of a signal 44 period is less than the switchup point corresponding to the 3.0 Hz HP filter characteristic shown at U2 and logic 40 immediately selects the 3.0 Hz characteristic. As the flow increases to point E on curve 19, the 6.0 Hz HP filter characteristic is chosen using the same selection process. The response time of electronics 20 when successively higher frequency corner HP filters are selected decreases as the flow increases. In summary, logic 40 selects the filter characteristic having the next higher corner frequency relative to the corner frequency of the current filter characteristic when the period timer value, as sampled when signal 44 changes state, is less than the switchup point for such next higher corner frequency filter.

This selection process selects a filter having a corner one step away in frequency from the corner of the current filter characteristic. An alternative selection process can be configured to select a filter characteristic more than one step away in corner frequency than the current filter characteristic. In such a selection process, logic 40 compares the period timer value at the end of a period of signal 44 to the set of switchup points and selects the filter characteristic having a corner corresponding to the higher of the switchup points which bound the period timer value.

A different selection process is used for decreasing flows. Logic 40 compares the present timer value and the switchdown point assigned to the HP filter characteristic having the next lower frequency corner than the current filter characteristic. When the flow decreases and the point on curve 19 moves from point E through point D towards point C, the 6 Hz HP characteristic continues to be used as the filter characteristic of filter 36 until the present timer value exceeds the switchdown value assigned to point D3, at which time logic 40 selects for immediate use in filter 36 the 3 Hz HP characteristic. This same process continues as the flow decreases and the present timer values exceed successively larger switchdown values assigned to switchdown points D2 and D1, respectively, without receiving a period boundary to initiate selection. In summary, for a decreasing flow, logic 40 selects the filter characteristic having the next lower corner frequency relative to the corner frequency of the current filter characteristic when the present timer value exceeds a switchpoint corresponding to the filter characteristic having such next lower corner frequency. In other words, the corner frequency of HP filter 36 is adjusted in response to the frequency of signal 44 and selection logic 40 sets the filter corner frequency adequately below the frequency of signal 44. This method of selecting filter characteristics continues without resetting timer 46 until signal 44 changes state or until the filter characteristic having the lowest possible corner is activated, in which case timer 46 is stopped to avoid overflow. The next period boundary restarts timer 46. A small timing error results from the delay to set the HP filter 36 before timer 46 is reset, which is compensated by resetting timer 46 to the delay time instead of setting it to zero or by providing a latch to hold the value of counter 46 and restarting the timer.

The hysteresis effected by this method of filter characteristic selection ensures that a currently selected filter characteristics is selected over a broad range of frequencies. For example, signal 44 frequencies corresponding to timer values between U5 and D4 are filtered by the 12 Hz HP characteristic. Similarly, signal 44 frequencies corresponding to timer values between D2 and U3 are filtered by the 3 Hz characteristic. This feature ensures that frequency jitter of vortex signal 33 will cause minimal filter switching and therefore reduce undesirable noise.

Although the above discussed filter corners are selected to be separated in frequency by a factor of two, alternate arrangements are acceptable. A family of HP filters having corner frequencies separated by factors of the fourth root of two is preferred since it provides less sensitivity to noise and is convenient for a digital implementation of the filtering function.

The adaptive filter response disclosed above is considered open loop since changing the filter corner frequency has no affect on the period measurement which controls the filter. Adaptive response time allows one set of electronics 20 to be used for all meter sizes and flow ranges, even though the dynamic range of a vortex flowmeter varies from 1 Hz for 8" diameter meters carrying liquid to 6000 Hz for 1/2" diameter meters carrying gases.

Alternate vortex signal conditioning methods have disadvantages. Automatic gain control methods modify filter characteristics based on the amplitude of a vortex sensor output and consequently can track noise instead of the flow signal. Those methods utilizing a HP tracking filter (see for example US-A-3709034 or US-A-4966040) experience a loss of pulses during fast reductions in flow rate. In such electronics, a decreasing flow transient causes the HP filter to attenuate the flow signal because the time required for the tracking filter to change to a new filter selection was longer than the flow transient. The time constant is necessarily set by the lowest flow frequency and is therefore too large at high flow frequencies. This caused a loss of pulses, and consequently of flow rate output during such a transient. If, on the other hand, the HP filter corner was far from the vortex flow frequencies to avoid attenuation during a decreasing flow transient, then the effectiveness of the filter was reduced. The present invention avoids these transient problems due to both its unique self- adapting response time and the method by which HP filter characteristics are selected in the absence of a period boundary of signal 44, since the response time of the electronics decreases as the frequency of vortex signal 33 increases. This means that the electronics respond faster at high flow rates than they do at low flow rates.

The user initiated LP filter selection logic 38 selects a corner frequency for LP filter 34 as a function of the diameter of pipe 22 and the density of fluid 23. This selection is typically performed once during an application and needs to be changed, for example, when a meter size is changed or when fluid density is substantially changed. The corner can be selected via a hand-held communicator over a current loop, operator set manual dip switches, or an automated process which allows flowmeter 10 to select its proper setting and provide maximum noise immunity. For an automated setting, a flow rate is set in pipe 22 is which is approximately half the maximum flow rate for flowmeter 10. The operator then initiates the flowmeter's automatic LP filter selection process. Flowmeter 10 lowers the corner of LP filter 34 until the signal 44 is no longer a square wave. The corner frequency of LP filter 34 is then increased by a factor of approximately two to provide a factor of four between trigger 42 output and the voltage required for Schmitt trigger 42 to change state. A factor of approximately two is chosen because of the 1/F2 response on filter 34, which provides a factor of four change in amplitude. With proper communications electronics, selection and adjustment of the LP filters can be automatically achieved with an initiation command from an operator over a two wire current loop, after a stable midrange flow with an adequate signal to noise ratio has been established.

Pulse scaling circuit 50 converts square wave signal 44 into Fₒᵤₜ, which is representative of flow rate corresponding to a convenient unit of measure such as pulses per gallon. Circuit 50 is preferably digital in order to guarantee accuracy, provide a wide range of multiplication factors and space the output pulses evenly. Output circuit 52 converts square wave signal 44 into a 4-20 mA current representative of the flow. Circuit 52 is coupled to a current loop commonly used in the process control industry. Some flowmeters have an alternate embodiment of output circuit 52 which outputs digital information, representative of flowmeter status parameters and flow, superimposed on the 4-20 mA current line or power line.

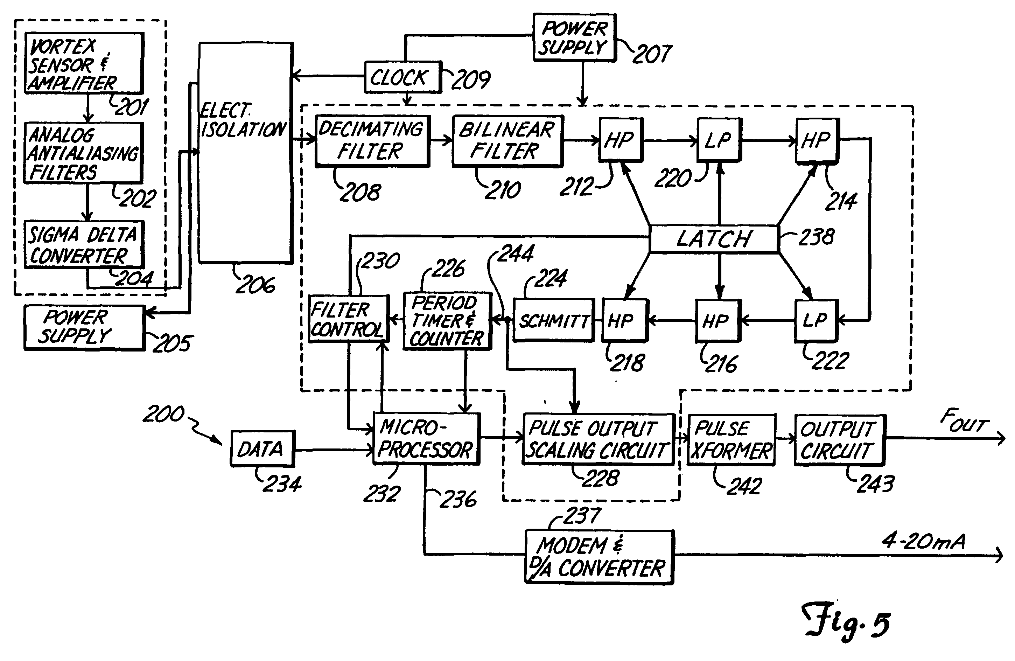

A digital embodiment of the present invention utilizing digital filters is indicated generally at 200 in FIG. 5. A digital implementation of the function described for flowmeter 200 is preferred because it is more powerful and flexible than analog filtering and can be under direct software control of a microprocessor in a smart transmitter. An analog anti-aliasing filter 202 receives the analog signal from a vortex flow sensor and amplifier 201. Filter 202 filters the sensor signal to remove unwanted high-frequency noise and performs anti-aliasing filtering.

Sigma-delta converter 204 samples the vortex signal at approximately 307.2 kHz and outputs a single bit datastream at 307.2 kHz which is representative of the amplitude and frequency of the output of vortex sensor and amplifier 201. There are no word boundaries in the datastream. The relative number of ones and zero, sometimes called the bit density, is representative of the amplitude of the vortex signal. Converter 204, which is preferably implemented in a CMOS ASIC to minimize power, cost and size, is particularly suited to digitizing AC signals in the one to ten kHz range which is a typical frequency range for vortex flow sensors. A sigma-delta converter simplifies electronics since circuits which synchronize the transmission of a data words or circuits which count the number of bits in a word are not needed. Preferably the output datastream has a frequency approximately 100 times greater than the typical maximum vortex frequency, which is between 1-6 kHz. Oversampling means moves quantization noise to higher frequencies. Subsequent digital filtering and decimation simplifies the anti-aliasing requirements and maintains the quantization noise inherent in sigma-delta converters at higher frequencies than the maximum vortex frequency. The sampling rate is chosen to be as low as possible to reduce power yet still have low noise amplitude in the vortex frequency band. This serial high-frequency format is ideal for transmission across an electrical isolation barrier 206 required for sensors which are grounded or have resistive leakage to ground due to high temperature loss of insulation resistance.

Such sensors are typically used in vortex flowmeters to reduce cost and simplify connections. Furthermore, the single bit datastream enables an inexpensive, compact transformer or capacitor to be used in isolator 206. Other isolation media are acceptable such as optical, piezoelectric/acoustic and magnetostrictive isolation means.

Two signals are transmitted across isolation 206. A power supply 207 supplies power to a clock 209 whose output signal is passed through isolation 206 and from there to power supply 205, which squares the clock signal and provides as a clock to circuits 201-204. The clock signal is also rectified and voltage regulated to operate as a power source for circuits 201-204. This arrangement also synchronizes clocks on both sides of barrier 206. Secondly, the serial bitstream from converter 204 is passed through isolation 206 in the other direction to a digital decimating filter 208. Isolator 206 isolates the grounded vortex sensor from the 4- 20 mA current loop of the flowmeter to avoid noise and currents in ground loops. Decimating filter 208 increases the width of the data word from one bit wide to ten bits wide and reduces the sampling frequency by a factor of ten to 30.72 kHz. Filter 208 reduces the amplitude of quantization noise and prevent aliasing of higher frequency signals caused by the decimation. The decimation factor is chosen so the decimation sampling rate is five to eight times greater than the highest frequency of the vortex signal in order to use simple digital filters in subsequent stages. Output of decimating filter 208 is received by a LP infinite impulse response filter (IIR) 210 that was designed by a bilinear transformation from the analog to digital domain, using coefficients of 1/2 and 1/4 to allow register shifting to replace multiplying circuits. IIR filter 210 has a zero at one half the 30.72 kHz sampling frequency and a 3,259 Hz corner frequency chosen to be at the upper end of a typical frequency output for a one inch flowmeter. Thus, filter 210 does not attenuate the flow signal, but minimizes unwanted high frequency quantization noise present in the sigma delta converter. The decimating and bilinear filters are not required when other methods of analog to digital conversion are used.

Infinite impulse filter (IIR) 212 receives the output of IIR filter 210. Filters 212-222 are serially connected in the following order: filter 212, filter 220, filter 214, filter 222, filter 216, and then filter 218. Each filter is a digital representation of a single pole low pass filter or a single pole high pass filter. An analog implementation of the circuit would also use two LP filters and four HP filters each having a single pole. HP and LP filters 212-222 are ordered in this fashion to reduce transients caused when HP filter characteristics are switched by microprocessor 232, since HP filter transients have high frequency components which are not attenuated by succeeding HP filters. Otherwise, the digital equivalent of Schmitt trigger 224 may produce extra output pulses. By interleaving the HP and LP filters as indicated, this transient effect is attenuated sufficiently to substantially eliminate the effect. Schmitt trigger 224 receives the output of filter 218 which generates a square wave vortex signal 244 having substantially the same frequency as the frequency of the output of vortex sensor and amplifier 201. Timer and period counter 226 outputs the elapsed time since a last period boundary of signal 244 to filter control 230, and the time between period boundaries of signal 244. The function of counter 226 with respect to the elapsed time is equivalent to the function of timer 46 in FIG. 1.

Logic 230 operates similarly to HP selection logic 40. Logic 230 receives switchup and switchdown values corresponding to each of the preselectable HP filter characteristics from micro 232 and recognizes which HP filter characteristic is currently used in each of the HP filters 212,214,216,218, (the "current filter characteristic"). As discussed above in conjunction with FIG. 3, there is a switchup and a switchdown value associated with each HP filter characteristic. Logic 230 also continually monitors the value from period timer and counter 226, (the "present timer value"). For an increasing flow, logic 230 sends an interrupt to microprocessor 232 when the filter characteristic having the next higher corner frequency relative to the corner frequency of the current filter characteristic when the present timer value, as sampled at a period boundary of signal 244, is less than the switchup point for such next higher corner frequency filter. For a decreasing flow, logic 230 interrupts micro 232 when the filter characteristic having the next lower corner frequency relative to the corner frequency of the current filter characteristic when the present timer value exceeds a switchdown value corresponding to the filter characteristic having such next lower corner frequency. The adaptive filter response of filters 212-218 is open loop since changing the filter corner frequency has no affect on the period measurement which controls the filter.

It is preferable for each filter to have a single variable pole, so that the corner frequency of the combined filter output has finer frequency resolution than if a single x-pole filter corner frequency were chosen. For example, four single HP filters each having independently variable corners have a combined corner frequency characteristic which changes as the fourth root of two, whereas a single four pole filter would have a corner characteristic variable in factors of two. Use of shift registers to perform multiplication is another simplifying design choice which reduces power consumption and the number of digital gates needed for each filter. As the digital filter output is the sum of first order terms each consisting of the product of a coefficient and a variable, when the coefficients multiplying the variables are chosen to be factors of one-half, only shift registers are required where a full multiplier circuit would otherwise be needed. For this reason, corner frequencies are only adjustable in factors of two. It is also preferable to implement the filters and associated circuitry placed within dashed box 250 into an ASIC to conserve power and for ease of assembly.

Microprocessor 232 calculates appropriate corner frequencies for filters 212-222 and sends corner selection commands representative of the proper HP filter characteristic to filter control 230 and to filter selection latch 238. Latch circuit 238 distributes filter selection values to filters 212-222. Microprocessor 232 also performs supervisory functions, optional output conditioning and required communications between the flowmeter and a process control system which receives the flowmeter output. An example of a supervisory function is disabling filter tracking, whereas examples of output conditioning are setting damping and alarm limits, and low flow cutoff, depending on user preference data contained in application data block 234.

Signal 244 operates timer and a period counter 226 which interrupts micro 232 with data representative of the frequency of signal 244. The interruption occurs approximately every tenth of a second or once each period of signal 244, whichever represents the longer amount of time. After interruption, micro 232 calculates an updated vortex frequency and provides such output digitally on output 236. Converter and modem 237 converts the digital information encoded on output 236 to a 4-20mA current representative of the flow. Other output formats, such as Fieldbus or other process control industry standard communications formats can be used as appropriate. Micro 232 also provides a signal to pulse output scaling circuit 228 which provides the necessary signals to operate a pulse transformer 242. Pulse transformer 242 provides an electrically isolated signal to output circuit 243. Circuit 243 provides a frequency output Fₒᵤₜ representative of the flow.

## Claims

1. A transmitter sensing a physical parameter and transmitting an output representative of such physical parameter, comprising:
filter means (34,36,212,220) for filtering a noise contaminated signal having a fundamental frequency varying responsively to the physical parameter, the filter means filtering the noise with a current HP filter characteristic to produce a filtered signal having a frequency representative of the physical parameter, the HP filter characteristic selected from a family of preselectable HP filters, each filter having varying corner frequencies and a switchup and a switchdown value corresponding thereto;
timer means (46,226) for providing a period timer value representative of the time between period boundaries of the filtered signal and for providing a present timer value representative of the elapsed time since a last period boundary of the filtered signal;
adaptive response means (40,230) for selecting a current HP filter for use in the filter means, such that a HP filter corner higher in frequency than the current filter corner is selected when the period timer value is less than a switchup value corresponding to the filter having such next higher corner frequency and a HP filter corner lower in frequency than the current filter corner is selected when the present timer value exceeds a switchdown value corresponding to such lower filter characteristic; and
output means for converting the filtered signal into the transmitter output.

2. The transmitter of claim 1 wherein the filter means includes a selected LP filter means from a family of LP filters.

3. The transmitter of claim 1 further comprising Schmitt trigger means (42) receiving the filtered signal and coupled via the timer means (46) to the adaptive response means (40) for providing a stable filtered signal to the adaptive response means.

4. The transmitter of claim 3 where the filter means includes LP filter means for selecting a LP filter characteristic from a family of LP filters characteristics, each having a low frequency corner, such that in an automated LP corner setting mode, the LP filter means decreases the frequency of the LP filter corner frequency until a first corner frequency is encountered where the output of the Schmitt trigger is no longer a square wave, and then increases such first corner frequency to a second corner frequency greater than the first corner frequency.

5. The transmitter of claim 1 where the HP filter characteristic is provided by cascaded HP filters each having a single pole, and where the adaptive response means switch no more than one single pole filter at a time so as to minimize the difference in frequency between two successively selected corners.

6. The transmitter of claim 1 further comprising sigma delta analog-to-digital converter means for converting the noise contaminated input signal to a digital signal represented by a serial one-bit signal provided to the filter means.

7. The transmitter of claim 6 further comprising isolation means coupled between the sigma-delta converter means and the filter means for providing electrical isolation therebetween, where the isolation means receives the serial bitstream and transmits it to the filter means and a power supply signal from the filter means is transmitted through the isolation means to the converter means for providing power therefor.

8. A method for reducing noise to signal ratio of a noise contaminated input signal which has a fundamental frequency varying responsively to a physical parameter and providing a signal with a frequency proportionally representative of the input signal fundamental frequency, the method comprising:
measuring the output frequency to obtain a measured output frequency value by measuring time between period boundaries of the signal;
measuring an elapsed time since an occurrence of a last period boundary in the signal; and
controlling a HP filter characteristic as a function of the measured output frequency value such that the HP filter characteristic is raised when the period of the signal is less than the period corresponding to a higher frequency characteristic and the HP filter characteristic is lowered when the elapsed time since a last period boundary of the signal exceeds the period corresponding to a lower frequency filter characteristic.

9. The transmitter of claim 8 where the conversion means is a sigma-delta converter.

## Patentansprüche

1. Sender, welcher einen physikalischen Parameter erfaßt und ein Ausgangssignal sendet, welches einen solchen physikalischen Parameter darstellt, und welcher folgendes aufweist:
- Filtervorrichtung (34, 36, 212, 220) zum Filtern eines verrauschten Signals, wobei die Filtervorrichtung eine Grund-frequenz aufweist, welche ansprechend auf den physikalischen Parameter variiert, die Filtervorrichtung weiter das Rauschen mit Hilfe einer Strom-Hochpaßfilter-Kennlinie zur Erzeugung eines gefilterten Signals, das eine den physikalischen Parameter wiedergebende Frequenz aufweist, filtert, wobei die Hochpaßfilter-Kennlinie aus der Familie von voreinstellbaren Hochpaßfiltern ausgewählt wird, und jedes Filter variierende Eckfrequenzen und einen dementsprechenden Aufwärtsschalt- bzw. Abwärtsschaltwert aufweist;
- Zeitgebervorrichtung (46, 226) zur Lieferung eines Zeitintervallwerts, welcher die Zeit zwischen den Zeitintervallgrenzen des gefilterten Signals darstellt und weiter zur Lieferung eines gegenwärtigen Zeitintervallwerts, welcher die verstrichene Zeit seit einer letzten Zeitintervallgrenze des gefilterten Signals darstellt, dient;
- adaptive Ansprechvorrichtung (40, 230) zur Auswahl eines Strom-Hochpaßfilters für die Verwendung in der Filtervorrichtung, so daß eine Hochpaß-Filterkante selektiert wird, die eine höhere Frequenz als die Strom-Filterkante aufweist, sobald der Zeitintervallwert kleiner als ein Aufwärtsschaltwert entsprechend dem Filter ist, das eine solche nächste höhere Eckfrequenz aufweist, und eine Hochpaßfilterkante, welche eine niedrigere Frequenz als die Strom-Filterkante aufweist, selektiert wird, sobald der vorliegende Zeitintervallwert einen Abwärtsschaltwert, welcher einer solchen niedrigeren Filter-Kennlinie entspricht, übersteigt; und
- eine Ausgangsvorrichtung für die Umwandlung des gefilterten Signals in das Senderausgangssignal.

2. Sender nach Anspruch 1, dadurch gekennzeichnet, daß die Filtervorrichtung eine ausgewählte Tiefpaßfiltervorrichtung aus einer Familie von Tiefpaßfiltern aufweist.

3. Sender nach Anspruch 1, dadurch gekennzeichnet, daß der Sender weiter eine Schmitt-Trigger-Vorrichtung (42) aufweist, welche das gefilterte Signal empfängt und über die Zeitgebervorrichtung (46) mit der adaptiven Ansprechvorrichtung (40) zur Lieferung eines stabilen Filtersignals verbunden ist.

4. Sender nach Anspruch 3, dadurch gekennzeichnet, daß die Filtervorrichtung eine Tiefpaßfiltervorrichtung zur Auswahl einer Tiefpaßfilter-Kennlinie aus einer Familie von Tiefpaßfiltern aufweist, wobei jedes Tiefpaßfilter eine Niedrigfrequenzkante aufweist, so daß die Tiefpaßfiltervorrichtung in einem automatisierten Tiefpaßfilter-Ecken-Einstellmodus die Frequenz des Tiefpaßfilters reduziert, bis eine erste Eckfrequenz angetroffen ist, bei welcher die Ausgabe der Schmitt-Trigger-Vorrichtung keine Rechteckwelle mehr ist, und anschließend die Filtervorrichtung eine derartige erste Eckfrequenz auf eine zweite, im Vergleich zur ersten Eckfrequenz größeren Eckfrequenz, erhöht.

5. Sender nach Anspruch 1, bei welchem die Hochpaßfilter-Kennlinie mit Hilfe von Kaskaden-Hochpaßfiltern erzeugt wird, wobei jedes Kaskaden-Hochpaßfilter mit einem Pol ausgeführt ist, und bei welchem sich die adaptive Ansprechvorrichtung nicht mehr als ein Filter mit einem Pol zu einer bestimmten Zeit umschaltet, so daß der Frequenzunterschied zwischen zwei nacheinanderfolgend selektierten Kanten reduziert wird.

6. Sender nach Anspruch 1, dadurch gekennzeichnet, daß er weiter Sigma-Delta-Analog-Digital-Umwandlervorrichtungen für die Umwandlung des verrauschten Eingangssignals in ein digitales Signal aufweist, wobei das digitale Signal mit Hilfe eines seriellen Ein-Bit-Signals, welches an die Filtervorrichtung übermittelt wird, dargestellt ist.

7. Sender nach Anspruch 6, welcher weiter eine Isoliervorrichtung, welche zwischen der Sigma-Delta-Umwandlervorrichtung und der Filtervorrichtung zur Schaffung einer elektrischen Isolierung zwischen diesen gekoppelt ist, aufweist, wobei die Isoliervorrichtung den seriellen Bitstrom empfängt und diesen an die Filtervorrichtung sendet, und ein Stromversorgungssignal von der Filtervorrichtung durch die Isoliervorrichtung an die Umwandlervorrichtung zur Lieferung von Energie übertragen wird.

8. Verfahren zur Reduzierung des Verhältnisses von Rauschen zu Signal eines verrauschten Eingangssignals, wobei das verrauschte Eingangssignal eine Grundfrequenz aufweist, welche ansprechend auf einen physikalischen Parameter variiert und ein Signal mit einer Frequenz liefert, welche proportional die Grundfrequenz des Eingangsignals darstellt, dadurch gekennzeichnet, daß das Verfahren folgendes aufweist:
- Erfassung der Ausgangsfrequenz zum Erhalt eines erfaßten Ausgangsfrequenzwerts durch die Erfassung der Zeit zwischen den Zeitintervaligrenzen des Signals;
- die Erfassung der Zeit, welche seit dem Auftreten einer letzten Zeitintervallgrenze in dem Signal verstrichen ist; und
- die Steuerung einer Hochpaßfilter-Kennlinie als eine Funktion des erfaßten Ausgangsfrequenzwerts, so daß sich die Hochpaßfilter-Kennlinie erhöht, sobald die Zeitdauer des Signals kleiner als die Zeitdauer entsprechend einer höheren Frequenz-Kennlinie ist, und die Hochpaßfilter-Kennlinie abgesenkt wird, sobald die Zeitdauer, welche seit der letzten Zeitintervallgrenze des Signals verstrichen ist, die Zeitdauer, welche einer niedrigeren Frequenzfilter-Kennlinie entspricht, übersteigt.

9. Sender nach Anspruch 8, dadurch gekennzeichnet, daß die Umwandlervorrichtung ein Sigma-Delta-Umwandler ist.

## Revendications

1. Transmetteur détectant un paramètre physique et transmettant un signal de sortie représentatif d'un tel paramètre physique, comprenant:
des moyens formant filtre (34,36;212,220) servant à filtrer un signal parasité par un bruit et possédant une fréquence fondamentale variant en réponse à un paramètre physique, les moyens formant filtre filtrant le bruit avec une caractéristique de filtre HP (passe-haut) courante pour produire un signal filtré possédant une fréquence représentative du paramètre physique, la caractéristique de filtre HP étant sélectionnée parmi une famille de filtres HP pouvant être présélectionnée, chaque filtre possédant des fréquences de coude variables et une valeur de commutation vers le haut et une valeur de commutation vers le bas, qui leur correspondent;
des moyens formant minuterie (46;226) pour délivrer une valeur de période de minuterie représentative de l'intervalle de temps entre les limites de la période du signal filtré à délivrer une valeur actuelle de minuterie représentative du temps écoulé depuis une dernière limite de période du signal filtré;
des moyens de réponse adaptative (40,230) pour sélectionner un filtre HP courant destiné à être utilisé dans les moyens formant filtre, de sorte qu'un coude du filtre HP, dont la fréquence est supérieure à celle du coude du filtre courant, est sélectionné lorsqu'une valeur de la période de minuterie est inférieure à une valeur de commutation vers le haut correspondant au filtre possédant une telle fréquence de coude supérieure, et un coude du filtre HP ayant une fréquence inférieure à celle du coude du filtre courant, est sélectionné lorsque la valeur de la minuterie dépasse une valeur de commutation vers le bas correspondant à une telle caractéristique de filtre inférieure; et
des moyens de sortie pour convertir le signal filtré en le signal de sortie du transmetteur.

2. Transmetteur selon la revendication 1, dans lequel les moyens formant filtre comprennent des moyens formant filtre LP (passe-bas) sélectionnés provenant d'une famille de filtres LP.

3. Transmetteur selon la revendication 1, comprenant en outre des moyens formant bascule de Schmitt (42), qui reçoivent le signal filtré et sont couplés par l'intermédiaire des moyens formant minuterie (46) aux moyens de réponse adaptative (40) pour délivrer un signal filtré stable aux moyens de réponse adaptative.

4. Transmetteur selon la revendication 3, dans lequel les moyens formant filtre incluent des moyens formant filtre LP servant à sélectionner une caractéristique de filtre LP parmi une famille de caractéristiques de filtres LP, chacun possédant un coude à basse fréquence de telle sorte que dans un mode de réglage de coude LP automatisé, les moyens formant filtre LP réduisent la fréquence du coude du filtre LP jusqu'à ce qu'une première fréquence de coude soit rencontrée, pour laquelle le signal de sortie de la bascule de Schmitt n'est plus une onde carrée, puis augmentent une telle première fréquence de coude jusqu'à une seconde fréquence de coude supérieure à la première fréquence de coude.

5. Transmetteur selon la revendication 1, dans lequel la caractéristique de filtre HP est fournie par des filtres HP branchés en cascade, dont chacun possède un seul pôle, et dans lequel les moyens de réponse adaptative ne commutent pas plus d'un filtre à un seul pôle à un instant donné de manière à réduire la différence entre les fréquences de deux coudes sélectionnés successivement.

6. Transmetteur selon la revendication 1, comprenant en outre des moyens formant convertisseurs analogiques/numériques sigma-delta servant à convertir le signal d'entrée parasité par un bruit en un signal numérique representé par un signal série à un bit envoyé aux moyens formant filtre.

7. Transmetteur selon la revendication 6, comprenant en outre des moyens d'isolation branchés entre les moyens formant convertisseur sigma-delta et les moyens formant filtre pour établir une isolation électrique entre ces moyens, les moyens d'isolation recevant le flux binaire en série et le transmettant aux moyens formant filtre, et un signal d'alimentation en énergie délivré par les moyens formant filtre est transmis par l'intermédiaire des moyens d'isolation aux moyens formant convertisseur pour délivrer une énergie à ces moyens.

8. Procédé pour réduire le rapport signal/bruit d'un signal d'entrée parasité par un bruit, qui possède une fréquence fondamentale variant en réponse à un paramètre physique, et pour délivrer un signal ayant une fréquence qui est proportionnellement représentative de la fréquence fondamentale du signal d'entrée, le procédé comprenant:
la mesure de la fréquence de sortie pour l'obtention d'une valeur de la fréquence de sortie mesurée, par mesure de la durée entre les limites de la période du signal;
la mesure d'un intervalle de temps écoulé depuis l'apparition d'une dernière limite de période dans le signal; et
la commande d'une caractéristique de filtre HP en fonction de la valeur de la fréquence de sortie mesurée de sorte que la caractéristique de filtre HP est élevée lorsque la période du signal est inférieure à la période correspondant à une caractéristique de fréquence plus élevée, et la caractéristique de filtre HP est abaissée lorsque l'intervalle de temps écoulé depuis une dernière limite de période du signal dépasse la période correspondant à une caractéristique de filtre à fréquence inférieure.

9. Transmetteur selon la revendication 8, dans lequel les moyens de conversion sont un convertisseur sigma-delta.
